# EUROPEAN PATENT SPECIFICATION

(11) **EP 4 067 921 B1**
(45) Date of publication and mention of the grant of the patent: **02.10.2024**
(21) Application number: 21305396.0
(22) Date of filing: 29.03.2021
(51) Int. Cl.: G01R 31/52, G01R 31/58

(54) **SHEATH INTEGRITY MONITORING**
ÜBERWACHUNG DER INTEGRITÄT EINER HÜLLE
SURVEILLANCE DE L'INTÉGRITÉ D'UNE GAINE

(43) Date of publication of application: 05.10.2022
(73) Proprietor: Nexans, 92400 Courbevoie (FR)
(72) Inventor: GASPARI, Roberto, 1182 OSLO (NO)
(74) Representative: Ipsilon

(56) References cited:
- EP-A2- 0 942 292
- WO-A1-2015/144199
- WO-A1-2016/008542
- JP-A- H08 304 487
- KR-A- 20200 036 479
- US-A1- 2018 154 776

## Description

### FIELD OF THE INVENTION

The present invention relates to a monitoring system for monitoring the state of an electric cable system. The present invention also relates to a method for monitoring the state of a sheath of a cable section of an electric cable system. The present invention also relates to a computer program product.

### BACKGROUND OF THE INVENTION

Electric high voltage cables are typically provided with an integral metallic sheath. The metallic sheath serves two purposes:
First, with the outer metallic sheath of the cable grounded, the electric stress distribution within the insulation attains radial symmetry and is confined to the insulation. This is an important safety consideration.
Second, the sheath is often used as the essential ground return path to carry the fault current in the event of a line-to-ground fault on the system. Thus, it must be able to carry this current for the time required to operate the overcurrent protective device without overheating and damaging the cable.

To prevent corrosion of the metallic sheaths and armors, the latter must be shielded from the environment by nonmetallic coverings.

In the high voltage cables, the metallic sheath is invariably protected by an extruded layer of PVC or polyethylene (PE) or other materials. This protective covering or jacket is required for a number of reasons. In order to provide some degree of mechanical protection to the underlying shield or sheath, the jacket must be tough and resistant to deformation both during and after installation of the cable.

A damage of the outer sheath of HVAC cables will lead to a deterioration of the cable performances and to an early failure of the energy link. The presence of a damage will create an additional earthing point leading to additional losses and at moisture access point into the cable with localized corrosion aided by the circulating currents through the earthing.

Document WO 2016/008542 A1 discloses an electrical cable link apparatus and an electrical cable system comprising the apparatus.

Document JP H08 304487 A discloses a method for insulation diagnosis of cable sheath in active condition.

Document EP 0 942 292 A2 discloses a method of and apparatus for detecting cable oversheath faults and installations in which they are used.

Document WO 2015/144199 A1 discloses a method of measuring current distribution in high and medium voltage cables.

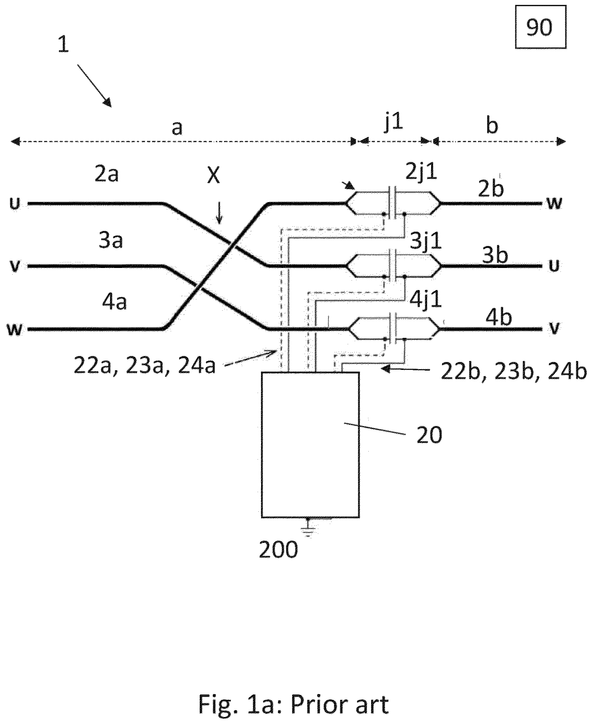

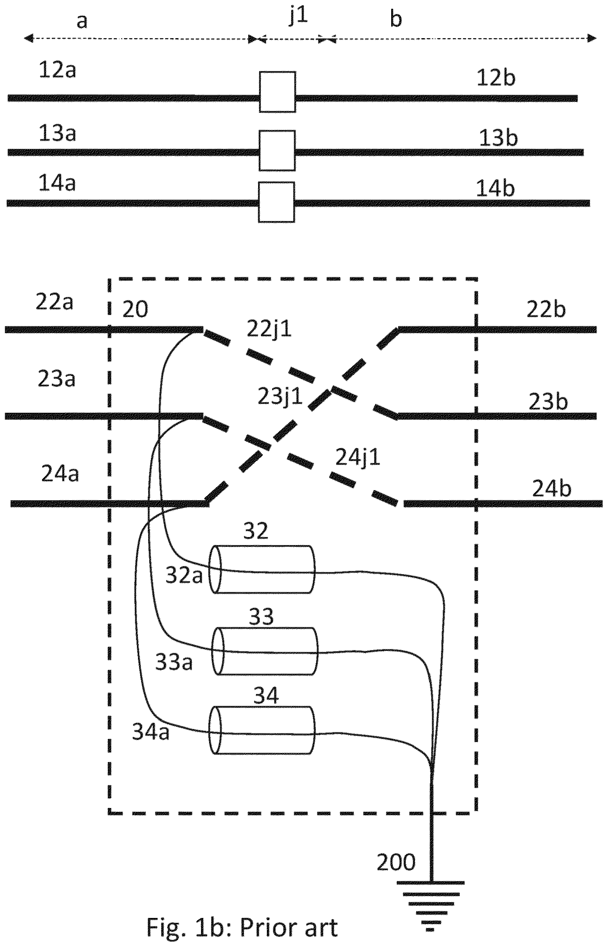

In fig. 1 a cable system 1 is shown to two lengths a and b of a three phase cable, one for each phase U, V and W. The length a comprises a first cable section 2a, 3a, 4a and the length b comprises a second cable section 2b, 3b, 4b, the cable sections being joined by means of joints 2j1, 3j1, 4j1. At the joints 2j1, 3j1, 4j1, the conductors of the cable sections are connected to each other, while the sheaths of the respective cable sections are brought to a cross-bonding box 20.

Due to operational requirements, i.e. minimization of losses, the phases U, W, W, the cables and the metallic sheaths are transposed at intervals, as indicated with the letter X in fig. 1a.

In fig. 1b, the cross-bonding box 20 is shown in detail. Here, the sheets 22a, 23a, 24a of the first cable sections 2a, 3a, 4a are connected to sheets 22b, 23b, 24b of the second cable sections 2b, 3b, 4b via cross-bonding connectors 22j 1, 23j 1, 24j 1. Above the cross-bonding box 20, it is also shown that the conductors 12a, 13a, 14a of the first cable section 2a, 3a, 4a are connected to the conductors 12b, 13b, 14b of the second cable section 2b, 3b, 4b by means of the joints 2j1, 3j1, 4j1.

The cross-bonding box 20 further comprises sheath voltage limiter elements 32, 33, 34 (hereinafter referred to as SVL elements) and earthing conductors 32a, 33a, 34a for connecting respective sheets 22a, 23a, 24a to ground 200 via the respective SVL elements 32, 33, 34. During normal operation, the current through the SVL elements are zero. However, current will go through the SVL elements in cases of overvoltage or lightning etc.

In order to verify the integrity of the sheath, a direct-current (dc) voltage test is normally carried out periodically to check that no damage has occurred. To facilitate application of the test voltage, a coating of colloidal graphite or some other conductive material is applied over the jacket during extrusion. In order to perform the test, the cable system 1 has to be taken out of operation.

One object of the present invention is to provide a monitoring system for a cable system where the integrity of the jacket can be verified with the cable system in operation.

### SUMMARY OF THE INVENTION

The present invention relates to a monitoring system for monitoring the state of an electric cable system according to claim 1.

As used herein, the term "cable section" refers to a length of cable of the cable system, as indicated by dashed arrows in fig. 1. The cable section may comprise one conductor. The cable section may comprise three conductors, one for each phase. Each conductor has its own sheath, but each pair of conductor/sheath may be integrated in one cable or may be provided as three separate cables.

In one aspect, the first current sensor comprises a Neel effect measuring coil.

In one aspect, the central control system is the control system of the electric cable system. Typically, the central control system comprises a user interface for an operator of the electric cable system.

In one aspect, the cable system comprises an earthing conductor electrically connected between a first end of the first sheath and ground; and wherein the first current sensor is measuring the current through the earthing conductor, wherein the current through the earthing conductor is the signal representative of the first current through the first end of the sheath.

In one aspect, the monitoring system comprises a second current sensor; wherein the second current sensor is measuring a signal representative of a second current through a second end of the sheath; the signal processing unit is connected to the second current sensor for processing of the signal representative of a second current through the second end of the sheath; and wherein the signal processing unit is configured to:
- determining a parameter representative of the state of the first sheath based on the signal from the first current sensor and the second current sensor.

In one aspect, the cable system comprises a second earthing conductor electrically connected between the second end of the first sheath and ground; wherein the second current sensor is measuring the current through the second earthing conductor.

In one aspect, the electric cable system comprises:
- a second cable section comprising a second conductor and a second sheath;
- a conducting element for connecting the first sheath to the second sheath;
wherein the second current sensor is measuring the current through the conducting element.

The parameter representative of the state of the first sheath is a current difference between the current through the sheath and an expected current value.

If the current difference is equal to zero, the current through the sheath is equal to the expected current value, indicating that no fault is present.

If the current difference is larger than or lower than zero, the current through the sheath is different from the expected current value, indicating that a fault is present.

In one aspect, the parameter representative of the state of the first sheath is a fault position for the fault in the first cable section.

In one aspect, the monitoring system further comprises:
- a temperature sensor for measuring a parameter representative of the temperature of the sheath, wherein the temperature sensor is connected to the signal processing unit.

According to the temperature sensor, a more accurate calculation of the electrical resistance of the sheath can be achieved, as the resistance of the sheath material is affected by its temperature. Hence, a more accurate calculation of the position fault can be achieved. The electrical resistance of the sheath is one property of the electric cable system being used to determine a position for the damage of the sheath.

Preferably the temperature sensor is a distributed temperature sensing unit.

Alternatively, there is no temperature sensor. Here, an assumed or estimated temperature is used for calculating the electrical resistance of the sheath.

The present invention also relates to a method for monitoring the state of a sheath of a cable section of an electric cable system according to claim 9.

In one aspect, the method further comprising the step of:
- determining the parameter representative of the state of the first sheath as a fault position indicating a position of a fault in the cable section.

In one aspect, the step of measuring the signal representative of the current through the sheath comprises:
- measuring a signal representative of a first current through a first end of the sheath;
wherein the method further comprises the steps of:
- measuring a signal representative of a second current through a second end of the sheath;
- determining the parameter representative of the state of the first sheath based on the first current through the first end of the sheath and based on the second current through the second end of the sheath.

The present invention also relates to a computer program product -according to claim 12.

According to the above, it is achieved a system and method which can be retrofitted to an existing cable, as there is no need for a sensing element being embedded into the cable during production.

According to the above, it is achieved a system and method which can be used during normal operation of the cable. Hence, there is no need to take the cable out of operation to perform monitoring.

### DETAILED DESCRIPTION

Embodiments of the invention will now be described with reference to the enclosed drawings, wherein:
Fig. 1a illustrates a prior art three phase cable system;
Fig. 1b illustrates the prior art cross-bonding box of fig. 1a;
Fig. 2a illustrates a first embodiment of a cable system with a monitoring system for monitoring sheath integrity;
Fig. 2b illustrates a second embodiment of a cable system with a monitoring system for monitoring sheath integrity;
Fig. 2c illustrates a third embodiment of a cable system with a monitoring system for monitoring sheath integrity;
Fig. 2d illustrates a fourth embodiment of a cable system with a monitoring system for monitoring sheath integrity;
Fig. 3 illustrates the current through the sheath under normal operation (one end of sheath connected to ground);
Fig. 4 illustrates the current through the sheath when a fault is present (one end of sheath connected to ground);
Fig. 5 illustrates the current through the sheath under normal operation (both ends of sheath connected to ground);
Fig. 6 illustrates the current through the sheath when a fault is present (both ends of sheath connected to ground);
Fig. 7 illustrates a flow chart of the method;
Fig. 8a illustrates a further embodiment of a cable system with a monitoring system for monitoring sheath integrity;
Fig. 8b illustrates an expected curve for the induced voltage in the sheath for one phase of the cable system in fig. 8a.

### First embodiment

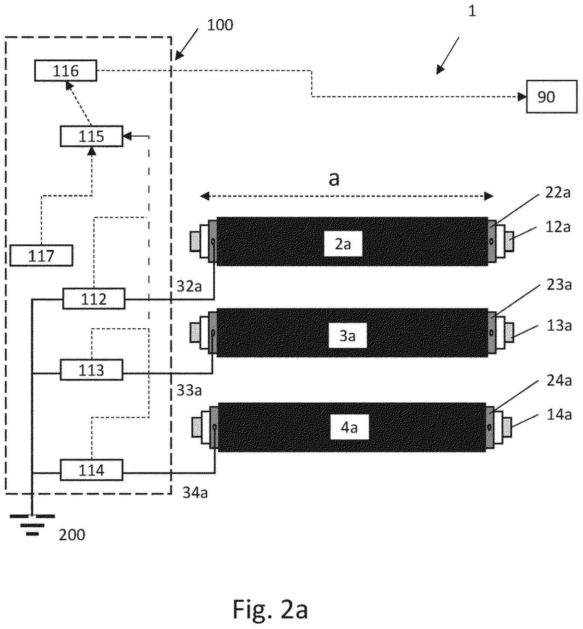

It is now referred to fig. 2a. Here it is shown a three-phase subsea cable system 1 comprising three cable sections 2a, 3a, 4a having a cable length a. Each cable section 2a, 3a, 4a has a first conductor 12a, 13a, 14a and a first sheath 22a, 23a, 24a. It should be noted that the cable system 1 in fig. 2a may comprise just these three cable sections 2a, 3a, 4a. Alternatively, the cable system 1 may comprise two or more cable sections connected to the first cable sections. It is also shown in fig. 2a that the cable system 1 comprises a control system 90 for monitoring and for controlling the cable system. The control system 90 typically monitors voltages, currents and other parameters of the cable system 1 and may be used to operate switches to connect/disconnect the cable system 1 to/from a power system.

A first end (the left end in fig. 2a) of the sheaths 22a, 23a, 24a is electrically connected to ground 200 via an earthing conductor 32a, 33a, 34a.

The above cable system 1 with its control system 90 is considered known and will not be described herein further in detail.

In fig. 2a it is also shown a monitoring system indicated as a dashed box 100.

The monitoring system 100 comprises a current sensor 112 for measuring the current through the earthing conductor 32a, a current sensor 113 for measuring the current through the earthing conductor 33a, and a current sensor 114 for measuring the current through the earthing conductor 34a. In the present embodiment, there is one sensor for each phase in the three-phase system, and they are in the description below commonly referred to as the first sensors 112, 113, 114. However, it should be noted that it is possible to have only one sensor, measuring the current through one of the earthing conductors 32a, 33a, 34a or measuring the sum of the currents through the earthing conductors 32a, 33a, 34a.

These first sensors 112, 113, 114 are measuring a signal representative of the current Is through the respective sheaths 22a, 23a, 24a. It should be noted that the current Is through the sheath 22a may be different from the current Is through the sheath 23a which again may be different from the current Is through the sheath 24a.

The first sensors 112, 113, 114 are Neel effect measuring coils. These Need effect measuring coils are relatively small in size, they are sensitive and have an appropriate measurement range. They can therefore be located within a cross-bonding box 20 or similar equipment at the ends of the cable sections or at joints at the cable sections. Hence, this makes it easy to retrofit the monitoring system 100 to existing cable systems 1.

The monitoring system 100 further comprises a signal processing unit 115 connected to the respective first sensors 112, 113, 114. The connections between the first sensors and the signal processing unit 115 are here shown as dashed lines, to separate these connections from the earthing conductors 32a, 33a, 34a.

Based on the signal from the current sensor 112, 113, 114, the signal processing unit 115 is configured to determine a parameter representative of the state of the respective first sheaths 22a, 23a, 24a.

In fig. 2a, it is further shown that the monitoring system 100 comprises a communication unit 116 providing communication between the signal processing unit 115 and the central control system 90.

The monitoring system 100 may further comprise a temperature sensor 117 connected to the signal processing unit 115 for measuring a parameter representative of the temperature of the sheath. Preferably the temperature sensor is a distributed temperature sensing unit. The distributed temperature sensing unit is here an optoelectronic device comprising an optical fiber and an electronic circuit, for measuring the temperature of the sheath along the majority of the sheath itself, to utilize a more accurate average temperature value instead of a point value.

In some cable systems, an optical fiber was integrated in the cable sections during manufacturing, and is therefore available at the joints of the cable sections.

However, a distributed fiber sensor may also be retrofitted. It is commonly known how to evaluate the temperature of different elements of the cable, and in particular of the metallic sheath when measuring temperature in a different, proximal, position.

Other types of sensors may also be used, for example temperature sensorsmeasuring the temperature over the cable surface, at one location, or as a number of sensors measuring the temperature in a quasi-distributed way over several singular positions distributed along the sheaths.

### Second embodiment

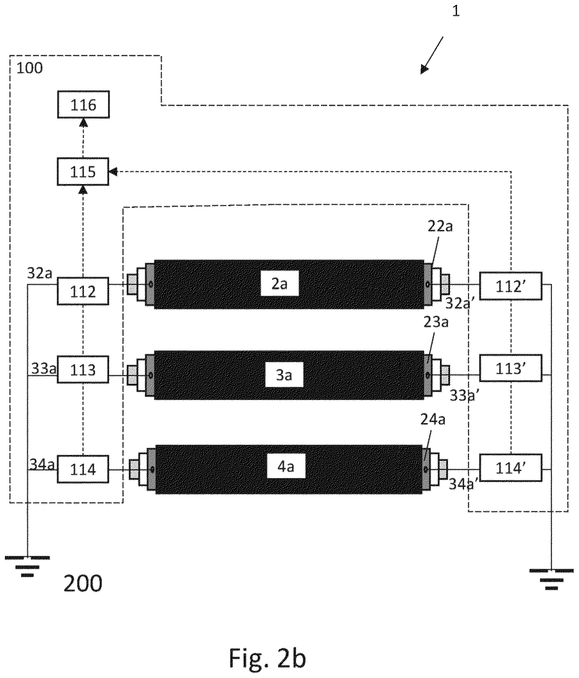

It is now referred to fig. 2b. The second embodiment is similar to the first embodiment, and only differences between the first and second embodiments will be described in detail herein.

In the first embodiment, only the first (the left) end of the sheaths 22a, 23a, 24a were connected to ground by means of the first earthing conductors 32a, 33a, 34a.

In the second embodiment, also the second (the right) end of the sheaths 22a, 23a, 24a are connected to ground by means of second earthing conductors 32a', 33a', 34a'.

The monitoring system 100 here comprises a current sensor 112' for measuring a current through the second earthing conductor 32a', a current sensor 113' for measuring a current through the second earthing conductor 33a', and a current sensor 114' for measuring a second current through the second earthing conductor 34a'. These sensors 112', 113', 114' are commonly referred to as the second current sensors 112', 113', 114', as they are measuring a signal representative of a second current Is2 through the second end of the sheath 22a, 23a, 24a.

As this second current is referred to as the second current Is2, the first current through the first end of the sheath is here referred to as the first current Is1.

As in the first embodiment, there are one sensor for each phase in the three-phase system. However, other alternatives are possible.

The second current sensors 112', 113', 114' are connected to the signal processing unit 115. The signal processing unit 115 is configured to determine a parameter representative of the state of the first sheath 22a, 23a, 24a based on the signals from the first current sensors 112, 113, 114 and the second current sensors 112', 113', 114'.

### Third embodiment

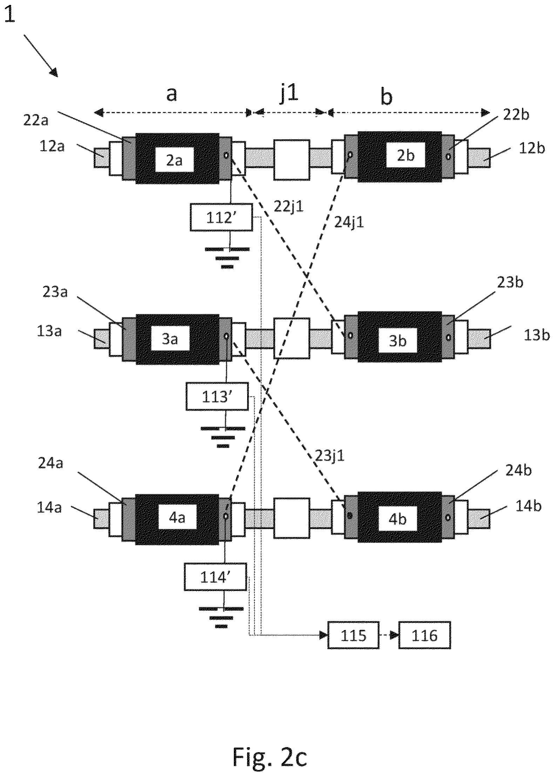

It is now referred to fig. 2c. The third embodiment has many similarities with the second embodiment above, and only differences between the third and second embodiments will be described in detail herein.

Here it is shown that the cable system 1 comprises the first cable section 2a, 2b, 2c as in the second embodiment. In addition, the cable system 1 comprises a second cable section 2b, 3b, 4b indicated by a cable length b. The second cable section 2b, 3b, 4b comprises a second conductor 12b, 13b, 14b connected to the first conductor 12a, 13a, 14a. The second cable section 2b, 3b, 4b further comprises a second sheath 22b, 23b, 24b connected to the first sheath 22a, 23a, 24a by means of conducting elements 22j1, 23j1, 24j1.

The second current sensors 112', 113', 114' are here connected similar to the second embodiment. However, the second current sensors 112', 113', 114' are here measuring a signal representative of the sum of the current through the second end of the sheath 22a, 23a, 24a and the current through the first end of the first sheath.

The third embodiment is preferably used together with the first embodiment, i.e. the first end of first sheath being grounded. The third embodiment may also be used together with the second embodiment where the sheaths at both ends of the cable system 1 are grounded. The current sensors 112', 113', 114' in fig. 2c will here be intermediate current sensors.

### Fourth embodiment

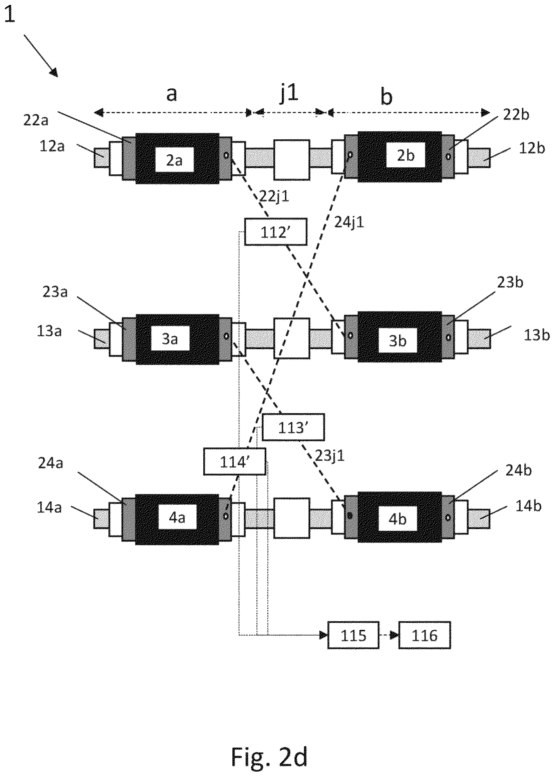

It is now referred to fig. 2d. The fourth embodiment has many similarities with the third embodiment above, and only differences between the fourth and third embodiments will be described in detail herein.

In the fourth embodiment, the second ends of the first sheaths 22a, 23a, 24a are not connected to ground. Here, the second current sensors 112', 113', 114' are measuring the current through the respective conducting elements 22j 1, 23j 1, 24j1 used to connect the first end (left side in fig. 2d) of the second sheath 22b, 23b, 24b to the second end (right side in fig. 2d) of the first sheath 22a, 23a, 24a.

### Fifth embodiment

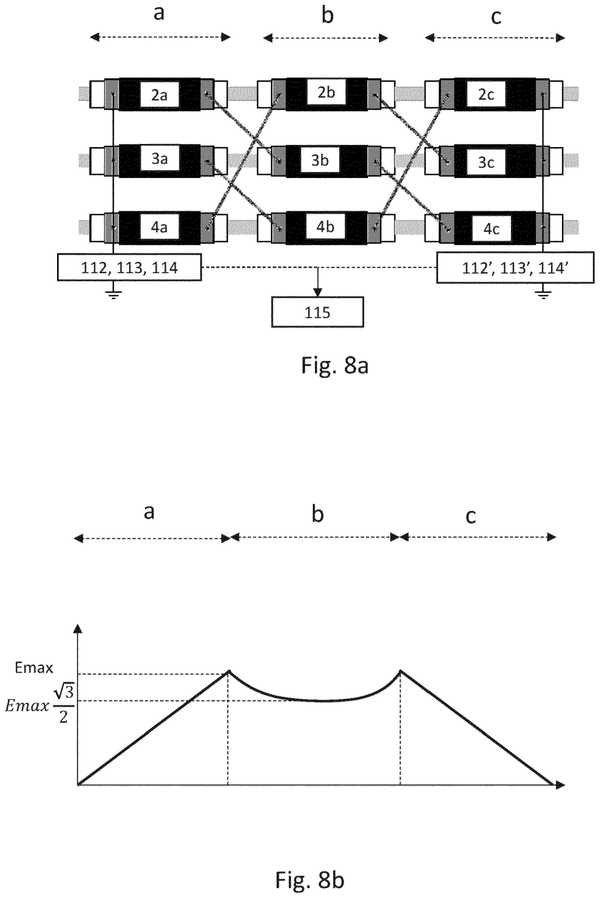

It is now referred to fig. 8a. The fifth embodiment has many similarities with the second embodiment above and only differences between the fourth and third embodiments will be described in detail herein.

In the fifth embodiment, each phase of the cable system 1 comprises three cable sections. The first cable section is indicated as 2a, 3a, 4a, the second cable section is indicated as 2b, 3b 4b, and the third cable section is indicated as 2c, 3c, 4c. The sheaths between the cable sections are cross-bonded to each other at the joints. However, the sheaths are not connected to ground at the joints. Hence, the fifth embodiment is similar to the second embodiment in that only the ends of the interconnected sheaths are connected to ground as indicated in fig. 8a.

It is also shown in fig. 8a that current sensors 112, 113, 114 are measuring the currents between the respective sheaths and ground at the first end, and that current sensors 112', 113', 114' are measuring the currents between the respective sheaths and ground at the second end.

### Monitoring operation

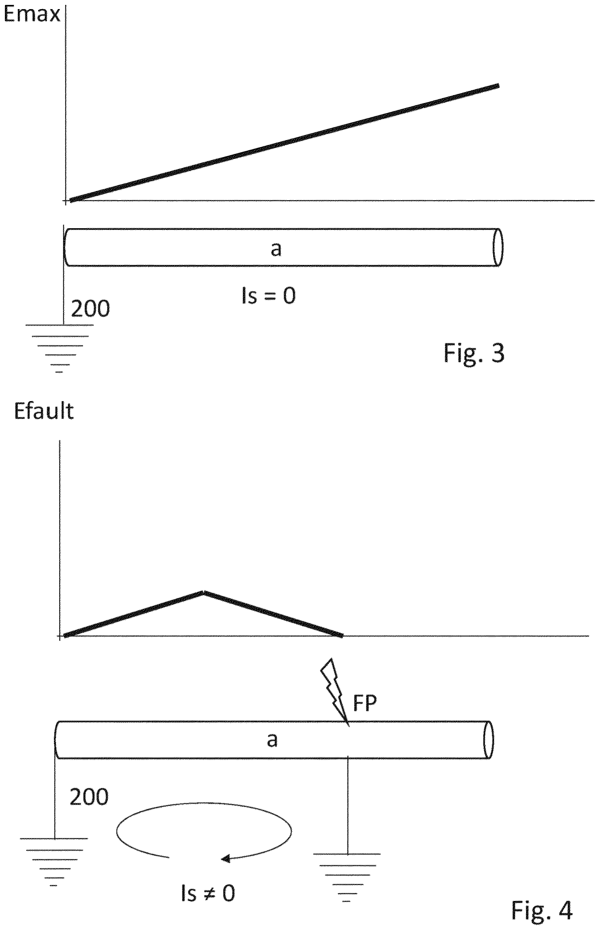

The method of monitoring the state of the of the sheath will now be described with reference to fig. 3 - 7.

Initially, the first embodiment will be described. In step S1, the signal processing unit 115 is receiving the signal representative of the current through the first end of the sheaths 22a, 23a, 24a.

A first parameter representative of the state of the first sheath 22a, 23a, 24a is a current difference ΔI between the current Is through the sheath 22a, 23a, 24a and an expected current value Ie. In step S2, the current Is is compared with an expected current value Ie.

It is known from literature that the sheath circulating current is linearly dependent on the induced voltage, the fault position and the circulating current circuital impedance.

Each cable system is characterized by its sheath maximum induced voltage Emax such maximum induced voltage is a characteristic of the energy transmission link geometry, depending e.g. on the distance among phases, the soil characteristics, the cable geometry and dimensions.

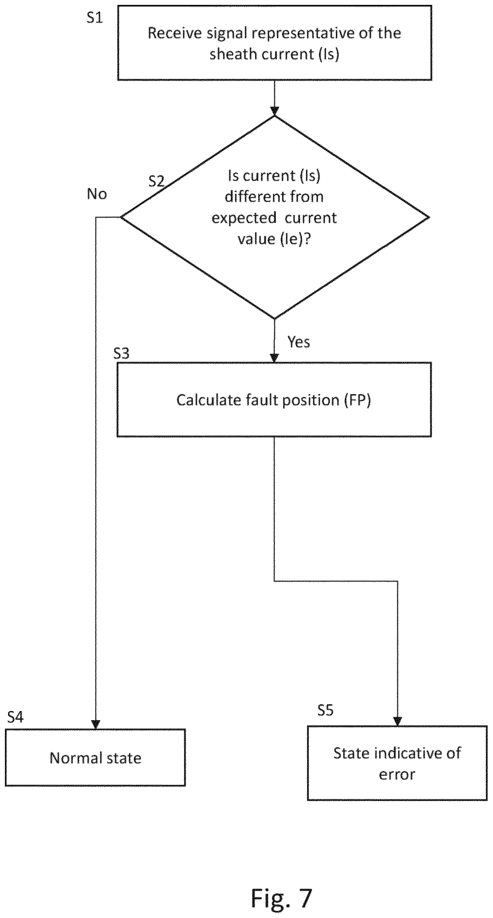

In fig. 3 a normal situation (i.e. no fault is present) for the first embodiment is shown. As only the first end of the sheath is connected to ground 200, the induced voltage Emax will increase along the length of the first sheath. The expected current value Ie is here zero, the measured current Is is zero and hence the current difference ΔI is also zero. Hence, a normal state is determined (indicated in fig. 7 as S4).

In fig. 4, a fault in the sheath is present at a fault position FP, causing the sheath to be grounded at this fault position FP. This will change the induced voltage, indicated in fig. 4 as Efault, and also the current through the sheath. The after-fault induced voltage Efault is proportional to the ratio of the minor section length to the distance among the design earthing point and the fault location.

The current Is will flow through the sheath between the first end of the sheath and the fault position FP. The current difference ΔI is now different from zero.

A second parameter representative of the state of the first sheath 22a, 23a, 24a is the fault position FP for the fault in the first cable section 2a, 3a, 4a.

In step S3, this fault position FP is calculated. The impedance per length unit of sheath can be determined from properties of the cable itself and cable geometry. In addition, the impedance per length unit will be more accurately determined by taking the temperature of the sheath into consideration.

At the same time the circuital impedance can be evaluated as the sum of the sheath resistance, linearly dependent to the faulted length between earthing points, the ground resistance (independent from the distance from grounding points), and the distance assumed by the return current from the cable sheath. This third factor is also independent from the distance between earthing points.

This all leads to the fact that there is a direct and unambiguous relation between the circulating current and the distance between the sheath fault and the system earthing points.

Therefore, by measuring the circulating current it is possible to derive the distance of the fault from a pre-fault earthing point as a ratio of the minor section length of the energy link.

Since the geometry of the system is invariable in time it is therefore possible to locate the fault position on the link itself.

According to the above, the state of the first sheath is now that a fault is present and the fault position FP is also known (indicated in fig. 7 as S5). This can be communicated as an error notification via the communication unit 116 to the control system 90.

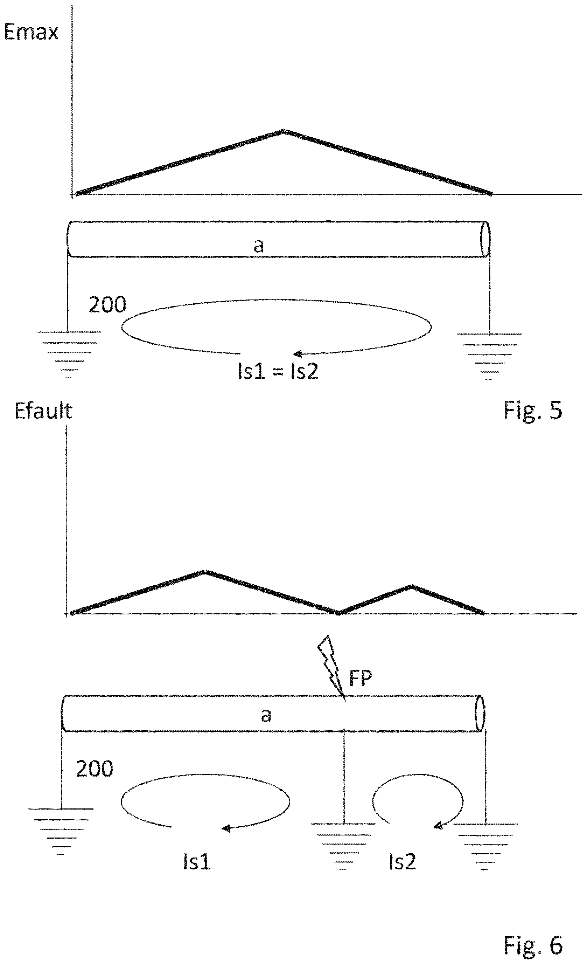

Now, the second embodiment will be described. In fig. 5, it is shown that the absolute value of the first current Is1 (measured as a current through the first end of the sheath) is equal to the absolute value of the second current Is2 (measured as a current through the second end of the sheath).

The expected value Ie for the first current Is1 is here different from zero, and the expected value Ie for the second current Is2 is here different from zero.

In fig. 6, it is shown a fault at the fault position FP, creating a path to ground. As shown, the induced voltage Efault is different from Emax, the first current Is 1 changes, and the second current Is2 changes. Here, one error may result in one or two error notifications.

The fault position FP can be calculated based on both the first and second currents Is1 and Is2. By using both the first and second currents Is1 and Is2, a more accurate fault position can be calculated.

In fig. 8b, the maximum induced voltage Emax for the sheath of one phase of the cable system 1 in fig. 8a is shown.

The above method will typically be performed by a computer program executed on the signal processing unit 15. It should be noted that the signal processing unit 15 itself does not need to determine if the SVL element should be replaced or when it should be replaced. This can be a manual operation, or an automatic operation, wherein additional factors than those mentioned above may be taken into consideration (for example economic factors and/or other technical factors).

### Alternative embodiments not forming part of the invention

It should be noted that the signal processing unit 115 may be located distant from the sensors 112, 113, 113 (and in some embodiments also sensors 112', 113', 114'), and that the unit 115 may be implemented as part of the central control system 90. In such a case, the communication unit 116 is providing communication between the sensors and the signal processing unit, wherein the signal representative of the current through the sheath is transferred by means of the communication unit from the sensors to the signal processing unit.

## Claims

1. Monitoring system (100) for monitoring the state of an electric cable system (1), wherein the electric cable system (1) comprises:
- a first cable section (2a, 3a, 4a) comprising a first conductor (12a, 13a, 14a) and a first sheath (22a, 23a, 24a);
wherein the monitoring system (100) comprises:
- a first current sensor (112, 113, 114) for measuring a signal representative of the current (Is; Is1) through the sheath (22a, 23a, 24a);
- a signal processing unit (115) connected to the first current sensor (112, 113, 114) for processing of the signal representative of the current (Is; Is) through the sheath (22a, 23a, 24a);
wherein the signal processing unit (115) is configured to:
- determining a parameter representative of the state of the first sheath (22a, 23a, 24a) of the first cable section (2a, 3a, 4a) of the electric cable system (1) based on the signal from the current sensor (112, 113, 114),
said monitoring system (100) further comprising:
- a communication unit (116) providing communication between the signal processing unit (115) and a central control system (90) and being **characterized in that** the parameter representative of the state of the first sheath (22a, 23a, 24a) is a current difference (ΔI) between the current (Is) through the sheath (22a, 23a, 24a) and an expected current value (Ie).

2. Monitoring system according to claim 1, wherein the first current sensor (112, 113, 114) comprises a Neel effect measuring coil.

3. Monitoring system according to any one of the above claims, wherein the cable system (1) comprises an earthing conductor (32a, 33a, 34a) electrically connected between a first end of the first sheath (22a, 23a, 24a); and ground (200); and wherein the first current sensor (112, 113, 114) is measuring the current through the earthing conductor (32a, 33a, 34a), wherein the current through the earthing conductor (32a, 33a, 34a) is the signal representative of the first current (Is; Is1) through the first end of the sheath (22a, 23a, 24a).

4. Monitoring system according to claim 3, wherein:
- the monitoring system (100) comprises a second current sensor (112', 113', 114');
- the second current sensor (112', 113', 114') is measuring a signal representative of a second current (Is2) through a second end of the sheath (22a, 23a, 24a);
- the signal processing unit (115) is connected to the second current sensor (112', 113', 114') for processing of the signal representative of a second current (Is2) through the second end of the sheath (22a, 23a, 24a);
wherein the signal processing unit (115) is configured to:
- determining a parameter representative of the state of the first sheath (22a, 23a, 24a) based on the signal from the first current sensor (112, 113, 114)and the second current sensor (112', 113', 114').

5. Monitoring system according to claim 4, wherein the cable system (1) comprises a second earthing conductor (32a', 33a', 34a') electrically connected between the second end of the first sheath (22a, 23a, 24a); and ground (200); wherein the second current sensor (112', 113', 114') is measuring the current through the second earthing conductor (32a', 33a', 34a').

6. Monitoring system according to claim 4, wherein the electric cable system (1) comprises:
- a second cable section (2b, 3, 4b) comprising a second conductor (12b, 13b, 14b) and a second sheath (22b, 23b, 24b);
- a conducting element (22j1, 23j1, 24j1) for connecting the first sheath (22a, 23a, 24a) to the second sheath (22b, 23b, 24b);
wherein the second current sensor (112', 113', 114') is measuring the current through the conducting element (22j1, 23j1, 24j1).

7. Monitoring system according to any one of the above claims, wherein the parameter representative of the state of the first sheath (22a, 23a, 24a) is a fault position (FP) for the fault in the first cable section (2a, 3a, 4a).

8. Monitoring system according to any one of the above claims, wherein the monitoring system (100) further comprises:
- a temperature sensor (117) for measuring a parameter representative of the temperature of the sheath, wherein the temperature sensor (117) is connected to the signal processing unit (115).

9. Method for monitoring the state of a sheath (22a, 23a, 24a) of a cable section (2a, 3a, 4a) of an electric cable system (1), wherein the method comprises the steps of:
- measuring a signal representative of a current (Is; Is1) through the sheath (22a, 23a, 24a) in a monitoring system (100);
- determining a parameter representative of the state of the sheath (22a, 23a, 24a) based on the signal from the current sensor (112, 113, 114), in a signal processing unit (115) in said monitoring system (100);
- providing communication between the signal processing unit (115) and a central control system (90); said method being **characterized in that** it further comprises the step of:
- determining the parameter representative of the state of the first sheath (22a, 23a, 24a) as a current difference (ΔI) between the current (Is) through the sheath (22a, 23a, 24a) and an expected current value (Ie).

10. Method according to claim 9, wherein the method further comprising the step of:
- determining the parameter representative of the state of the first sheath (22a, 23a, 24a) as a fault position (FP) indicating a position of a fault in the cable section (2a, 3a, 4a).

11. Method according to claim 9, wherein the step of measuring the signal representative of the current (Is) through the sheath (22a, 23a, 24a) comprises:
- measuring a signal representative of a first current (Is1) through a first end of the sheath (22a, 23a, 24a);
wherein the method further comprises the steps of:
- measuring a signal representative of a second current (Is2) through a second end of the sheath (22a, 23a, 24a);
- determining the parameter representative of the state of the first sheath (22a, 23a, 24a) based on the first current (Is1) through the first end of the first sheath (22a, 23a, 24a) and based on the second current (Is2) through the second end of the first sheath (22a, 23a, 24a).

12. A computer program product, comprising a non-transitory computer readable storage medium comprising instructions that, when executed on a signal processing unit (115) in a monitoring system (100) according to any of claims 1-8, 4-9- causes the signal processing unit (115) to perform the steps of the method according to claim 9 - 11.

## Patentansprüche

1. Überwachungssystem (100) zum Überwachen des Zustands eines elektrischen Kabelsystems (1), wobei das elektrische Kabelsystem (1) Folgendes umfasst:
- einen ersten Kabelabschnitt (2a, 3a, 4a), umfassend einen ersten Leiter (12a, 13a, 14a) und einen ersten Mantel (22a, 23a, 24a);
wobei das Überwachungssystem (100) Folgendes umfasst:
- einen ersten Stromsensor (112, 113, 114) zum Messen eines Signals, das repräsentativ für den Strom (Is; Is1) durch den Mantel (22a, 23a, 24a) ist;
- eine Signalverarbeitungseinheit (115), die mit dem ersten Stromsensor (112, 113, 114) verbunden ist, zum Verarbeiten des Signals, das repräsentativ für den Strom (Is; Is) durch den Mantel (22a, 23a, 24a) ist;
wobei die Signalverarbeitungseinheit (115) zu Folgendem konfiguriert ist:
- Bestimmen eines Parameters, der repräsentativ für den Zustand des ersten Mantels (22a, 23a, 24a) des ersten Kabelabschnitts (2a, 3a, 4a) des elektrischen Kabelsystems (1) ist, basierend auf dem Signal von dem Stromsensor (112, 113, 114),
das Überwachungssystem (100) ferner umfassend:
eine Kommunikationseinheit (116), die eine Kommunikation zwischen der Signalverarbeitungseinheit (115) und einem zentralen Steuersystem (90) bereitstellt und **dadurch gekennzeichnet ist, dass** der Parameter, der repräsentativ für den Zustand des ersten Mantels (22a, 23a, 24a) ist, eine Stromdifferenz (ΔI) zwischen dem Strom (Is) durch den Mantel (22a, 23a, 24a) und einem erwarteten Stromwert (le) ist.

2. Überwachungssystem nach Anspruch 1, wobei der erste Stromsensor (112, 113, 114) eine Neel-Effekt-Messspule umfasst.

3. Überwachungssystem nach einem der vorherigen Ansprüche, wobei das Kabelsystem (1) einen Erdungsleiter (32a, 33a, 34a) umfasst, der elektrisch zwischen einem ersten Ende des ersten Mantels (22a, 23a, 24a) und Erde (200) verbunden ist; und wobei der erste Stromsensor (112, 113, 114) den Strom durch den Erdungsleiter (32a, 33a, 34a) misst, wobei der Strom durch den Erdungsleiter (32a, 33a, 34a) das Signal ist, das repräsentativ für den ersten Strom (Is; Is1) durch das erste Ende des Mantels (22a, 23a, 24a) ist.

4. Überwachungssystem nach Anspruch 3, wobei:
- das Überwachungssystem (100) einen zweiten Stromsensor (112', 113', 114') umfasst;
- der zweite Stromsensor (112', 113', 114') ein Signal misst, das repräsentativ für einen zweiten Strom (Is2) durch ein zweites Ende des Mantels (22a, 23a, 24a) ist;
- die Signalverarbeitungseinheit (115) mit dem zweiten Stromsensor (112', 113', 114') verbunden ist, zum Verarbeiten des Signals, das repräsentativ für einen zweiten Strom (Is2) durch das zweite Ende des Mantels (22a, 23a, 24a) ist;
wobei die Signalverarbeitungseinheit (115) zu Folgendem konfiguriert ist:
- Bestimmen eines Parameters, der repräsentativ für den Zustand des ersten Mantels (22a, 23a, 24a) ist, basierend auf dem Signal von dem ersten Stromsensor (112, 113, 114) und dem zweiten Stromsensor (112', 113', 114').

5. Überwachungssystem nach Anspruch 4, wobei das Kabelsystem (1) einen zweiten Erdungsleiter (32a', 33a', 34a') umfasst, der elektrisch zwischen dem zweiten Ende des ersten Mantels (22a, 23a, 24a) und Erde (200) verbunden ist; wobei der zweite Stromsensor (112', 113', 114') den Strom durch den zweiten Erdungsleiter (32a', 33a', 34a') misst.

6. Überwachungssystem nach Anspruch 4, wobei das elektrische Kabelsystem (1) Folgendes umfasst:
- einen zweiten Kabelabschnitt (2b, 3, 4b), umfassend einen Leiter (12b, 13b, 14b) und einen zweiten Mantel (22b, 23b, 24b);
- ein leitendes Element (22jl, 23j1, 24jl) zum Verbinden des ersten Mantels (22a, 23a, 24a) mit dem zweiten Mantel (22b, 23b, 24b);
wobei der zweite Stromsensor (112', 113', 114') den Strom durch das leitende Element (22j1, 23j1, 24j1) misst.

7. Überwachungssystem nach einem der vorherigen Ansprüche, wobei der Parameter, der repräsentativ für den Zustand des ersten Mantels (22a, 23a, 24a) ist, eine Fehlerposition (FP) für den Fehler in dem ersten Kabelabschnitt (2a, 3a, 4a) ist.

8. Überwachungssystem nach einem der obigen Ansprüche, wobei das Überwachungssystem (100) ferner Folgendes umfasst:
- einen Temperatursensor (117) zum Messen eines Parameters, der repräsentativ für die Temperatur des Mantels ist, wobei der Temperatursensor (117) mit der Signalverarbeitungseinheit (115) verbunden ist.

9. Verfahren zum Überwachen des Zustands eines Mantels (22a, 23a, 24a) eines Kabelabschnitts (2a, 3a, 4a) eines elektrischen Kabelsystems (1), wobei das Verfahren die folgenden Schritte umfasst:
- Messen eines Signals, das repräsentativ für einen Strom (Is; Is1) durch den Mantel (22a, 23a, 24a) in einem Überwachungssystem (100) ist;
- Bestimmen eines Parameters, der repräsentativ für den Zustand des Mantels (22a, 23a, 24a) ist, basierend auf dem Signal von dem Stromsensor (112, 113, 114) in einer Signalverarbeitungseinheit (115) in dem Überwachungssystem (100);
- Bereitstellen von Kommunikation zwischen der Signalverarbeitungseinheit (115) und einem zentralen Steuersystem (90);
wobei das Verfahren **dadurch gekennzeichnet ist, dass** es ferner den folgenden Schritt umfasst:
- Bestimmen des Parameters, der repräsentativ für den Zustand des ersten Mantels (22a, 23a, 24a) ist, als Stromdifferenz (ΔI) zwischen dem Strom (Is) durch den Mantel (22a, 23a, 24a) und einem erwarteten Stromwert (le).

10. Verfahren nach Anspruch 9, wobei das Verfahren ferner den folgenden Schritt umfasst:
- Bestimmen des Parameters, der repräsentativ für den Zustand des ersten Mantels (22a, 23a, 24a) ist, als Fehlerposition (FP), die eine Position eines Fehlers in dem Kabelabschnitt (2a, 3a, 4a) angibt.

11. Verfahren nach Anspruch 9, wobei der Schritt eines Messens des Signals, das repräsentativ für den Strom (Is) durch den Mantel (22a, 23a, 24a) ist, Folgendes umfasst:
- Messen eines Signals, das repräsentativ für einen ersten Strom (Is1) durch ein erstes Ende des Mantels (22a, 23a, 24a) ist;
wobei das Verfahren ferner die folgenden Schritte umfasst:
- Messen eines Signals, das repräsentativ für einen zweiten Strom (Is2) durch ein zweites Ende des Mantels (22a, 23a, 24a) ist;
- Bestimmen des Parameters, der repräsentativ für den Zustand des ersten Mantels (22a, 23a, 24a) ist, basierend auf dem ersten Strom (Is1) durch das erste Ende des ersten Mantels (22a, 23a, 24a) und basierend auf dem zweiten Strom (Is2) durch das zweite Ende des ersten Mantels (22a, 23a, 24a).

12. Computerprogrammprodukt, umfassend ein nicht-transitorisches computerlesbares Speichermedium, umfassend Anweisungen, die, wenn sie auf einer Signalverarbeitungseinheit (115) in einem Überwachungssystem (100) nach einem der Ansprüche 1-8 ausgeführt werden, die Signalverarbeitungseinheit (115) veranlassen, die Schritte des Verfahrens nach Anspruch 9-11 durchzuführen.

## Revendications

1. Système de surveillance (100) destiné à surveiller l'état d'un système de câble électrique (1), dans lequel le système de câble électrique (1) comprend :
- une première section de câble (2a, 3a, 4a) comprenant un premier conducteur (12a, 13a, 14a) et une première gaine (22a, 23a, 24a) ;
dans lequel le système de surveillance (100) comprend :
- un premier capteur de courant (112, 113, 114) destiné à mesurer un signal représentatif du courant (Is ; ls1) traversant la gaine (22a, 23a, 24a) ;
- une unité de traitement de signal (115) connectée au premier capteur de courant (112, 113, 114) pour traiter le signal représentatif du courant (Is ; ls1) traversant la gaine (22a, 23a, 24a) ;
dans lequel l'unité de traitement de signal (115) est configurée de manière à :
- déterminer un paramètre représentatif de l'état de la première gaine (22a, 23a, 24a) de la première section de câble (2a, 3a, 4a) du système de câble électrique (1) sur la base du signal provenant du capteur de courant (112, 113, 114), ledit système de surveillance (100) comprenant en outre :
- une unité de communication (116) fournissant la communication entre l'unité de traitement de signal (115) et un système de commande central (90), et **caractérisé en ce que** le paramètre représentatif de l'état de la première gaine (22a, 23a, 24a) est une différence de courant (ΔI) entre le courant (Is) traversant la gaine (22a, 23a, 24a) et une valeur de courant attendue (le).

2. Système de surveillance selon la revendication 1, dans lequel le premier capteur de courant (112, 113, 114) comprend une bobine de mesure à effet Neel.

3. Système de surveillance selon l'une quelconque des revendications précédentes, dans lequel le système de câble (1) comprend un conducteur de mise à la terre (32a, 33a, 34a) connecté électriquement entre une première extrémité de la première gaine (22a, 23a, 24a) et la terre (200) ; et
dans lequel le premier capteur de courant (112, 113, 114) mesure le courant traversant le conducteur de mise à la terre (32a, 33a, 34a), dans lequel le courant traversant le conducteur de mise à la terre (32a, 33a, 34a) est le signal représentatif du premier courant (Is ; Is1) traversant la première extrémité de la gaine (22a, 23a, 24a).

4. Système de surveillance selon la revendication 3, dans lequel :
- le système de surveillance (100) comprend un deuxième capteur de courant (112', 113', 114') ;
- le deuxième capteur de courant (112', 113', 114') mesure un signal représentatif d'un deuxième courant (Is2) traversant une deuxième extrémité de la gaine (22a, 23a, 24a) ;
- l'unité de traitement de signal (115) est connectée au deuxième capteur de courant (112', 113', 114') en vue du traitement du signal représentatif d'un deuxième courant (Is2) traversant la deuxième extrémité de la gaine (22a, 23a, 24a) ;
dans lequel l'unité de traitement de signal (115) est configurée de manière à :
- déterminer un paramètre représentatif de l'état de la première gaine (22a, 23a, 24a) sur la base du signal provenant du premier capteur de courant (112, 113, 114) et du deuxième capteur de courant (112', 113', 114').

5. Système de surveillance selon la revendication 4, dans lequel le système de câble (1) comprend un deuxième conducteur de mise à la terre (32a', 33a', 34a') connecté électriquement entre la deuxième extrémité de la première gaine (22a, 23a, 24a) et la terre (200) ; dans lequel le deuxième capteur de courant (112', 113', 114') mesure le courant traversant le deuxième conducteur de mise à la terre (32a', 33a', 34a').

6. Système de surveillance selon la revendication 4, dans lequel le système de câble électrique (1) comprend :
- une deuxième section de câble (2b, 3, 4b) comprenant un deuxième conducteur (12b, 13b, 14b) et une deuxième gaine (22b, 23b, 24b) ;
- un élément conducteur (22j1, 23j1, 24j1) destiné à relier la première gaine (22a, 23a, 24a) à la deuxième gaine (22b, 23b, 24b) ;
dans lequel le deuxième capteur de courant (112', 113', 114') mesure le courant traversant l'élément conducteur (22j1, 23j1, 24j1).

7. Système de surveillance selon l'une quelconque des revendications précédentes, dans lequel le paramètre représentatif de l'état de la première gaine (22a, 23a, 24a) est une position de défaut (FP) pour le défaut dans la première section de câble (2a, 3a, 4a).

8. Système de surveillance selon l'une quelconque des revendications précédentes, dans lequel le système de surveillance (100) comprend en outre :
- un capteur de température (117) destiné à mesurer un paramètre représentatif de la température de la gaine, dans lequel le capteur de température (117) est connecté à l'unité de traitement de signal (115).

9. Procédé de surveillance de l'état d'une gaine (22a, 23a, 24a) d'une section de câble (2a, 3a, 4a) d'un système de câble électrique (1), dans lequel le procédé comprend les étapes comprenant le fait de :
- mesurer un signal représentatif d'un courant (Is ; ls1) traversant la gaine (22a, 23a, 24a) dans un système de surveillance (100) ;
- déterminer un paramètre représentatif de l'état de la gaine (22a, 23a, 24a) sur la base du signal provenant du capteur de courant (112, 113, 114), dans une unité de traitement de signal (115) dudit système de surveillance (100) ;
- fournir la communication entre l'unité de traitement de signal (115) et un système de commande central (90) ; ledit procédé étant **caractérisé en ce qu'**il comprend en outre l'étape comprenant le fait de :
- déterminer le paramètre représentatif de l'état de la première gaine (22a, 23a, 24a) comme étant une différence de courant (ΔI) entre le courant (Is) traversant la gaine (22a, 23a, 24a) et une valeur de courant attendue (le).

10. Procédé selon la revendication 9, dans lequel le procédé comprend en outre l'étape comprenant le fait de :
- déterminer le paramètre représentatif de l'état de la première gaine (22a, 23a, 24a) comme étant une position de défaut (FP) indiquant une position d'un défaut dans la section de câble (2a, 3a, 4a).

11. Procédé selon la revendication 9, dans lequel l'étape de mesure du signal représentatif du courant (Is) traversant la gaine (22a, 23a, 24a) comprend le fait de :
- mesurer un signal représentatif d'un premier courant (Is1) traversant une première extrémité de la gaine (22a, 23a, 24a) ;
dans lequel le procédé comprend en outre des étapes comprenant le fait de :
- mesurer un signal représentatif d'un deuxième courant (Is2) traversant une deuxième extrémité de la gaine (22a, 23a, 24a) ;
- déterminer le paramètre représentatif de l'état de la première gaine (22a, 23a, 24a) sur la base du premier courant (Is1) traversant la première extrémité de la première gaine (22a, 23a, 24a) et sur la base du deuxième courant (Is2) traversant la deuxième extrémité de la première gaine (22a, 23a, 24a).

12. Produit-programme informatique comprenant un support de stockage non transitoire lisible par ordinateur comprenant des instructions qui, lorsqu'elles sont exécutées sur une unité de traitement de signal (115) dans un système de surveillance (100) selon l'une quelconque des revendications 1 à 8, amènent l'unité de traitement de signal (115) à mettre en oeuvre les étapes du procédé selon l'une quelconque des revendications 9 à 11.
